# EUROPÄISCHE PATENTSCHRIFT

(11) **EP 0 969 501 B1**
(45) Veröffentlichungstag und Bekanntmachung des Hinweises auf die Patenterteilung: **19.10.2005**
(21) Anmeldenummer: 99112146.8
(22) Anmeldetag: 24.06.1999
(51) Int. Cl.: H01L 21/331, H01L 21/332, H01L 21/329

(54) **Verfahren zur Herstellung von Leistungshalbleiterbauelementen**
Method of making power semiconductor components
Méthode de fabrication de composants de puissance semi-conducteurs

(30) Priorität: 02.07.1998 DE 19829614
(43) Veröffentlichungstag der Anmeldung: 05.01.2000
(73) Patentinhaber: SEMIKRON Elektronik GmbH & Co. KG, 90431 Nürnberg (DE)
(72) Erfinder: Herzer, Reinhard, Dr. habil., 98693 Ilmenau (DE); Netzel, Mario, Dr., 0642 Branunsbedra (DE)

(56) Entgegenhaltungen:
- EP-A- 0 313 000
- EP-A- 0 330 122
- PATENT ABSTRACTS OF JAPAN vol. 014, no. 133 (E-0902), 13. März 1990 (1990-03-13) & JP 02 001985 A (MITSUBISHI ELECTRIC CORP), 8. Januar 1990 (1990-01-08)
- PATENT ABSTRACTS OF JAPAN Bd. 009, Nr. 310 (E-364) 06 Dezember 1985 & JP 60 145 660 A (MITSUBISHI DENKI KK) 01 August 1985

## Beschreibung

Die Erfindung beschreibt ein Verfahren zur Herstellung von Leistungshalbleiterbauelementen auf der Basis eines PT (Punch- Through)- Typs gemäß Anspruch 1. Weitere Ausführungsformen der Erfindung ergeben sich aus dem Unteransprüchen. Vertikale Strukturen zur Bildung von Leistungshalbleiterbauelementen sind aus der Literatur des Standes der Technik mehrfach bekannt.

Solche Bauelemente werden als IGBT in EP 0 405 138 A2, als GTO US 4,910,573, als MCT in einem Artikel "Evolution of MOS- Bipolar Power Semiconductor Technology" (B. J. Baliga in Proceedings of the IEEE, Vol. 76, No. 4, April 1988) und als Diode in einem Artikel "Axial Recombination Center Technology for Freewheeling Diodes" (J. Lutz in Proceedings EPE, Sept. 1997, S. 1502-1506) ausgeführt.

Leistungshalbleiterbauelemente können im elektrischen Sinne mit einem Punch- Through- oder Non-Punch-Through-Konzept realisiert werden. Bei einem Non-Punch-Through-Konzept nach EP 0 330 122 A1 dehnt sich die Raumladungszone des sperrenden Übergangs bei der maximal möglichen Blockierspannung nicht über die gesamte Weite der niedrig dotierten Basiszone aus.

Im Falle eines PT- Konzepts, wie in EP 0 405 138 A2 beschrieben, würde die Weite der Raumladungszone bei maximaler Blockierspannung größer als die Weite der niedrig dotierten Basiszone sein. Hier muß an das Ende der Basiszone, welches der Sperrschicht abgewandt ist, ein Gebiet mit gleicher Leitfähigkeit, aber höherer Dotierung eingebracht werden. Dieses Gebiet wird im Sprachgebrauch als Stoppschicht oder Buffer bezeichnet und begrenzt die Ausdehnung der Raumladungszone.

Dieser grundlegende Sachverhalt gilt für alle Leistungsbauelemente mit mindestens einem eine hohe Spannung sperrenden Übergang wie sie z.B. in Form von IGBT, MCT, GTO, Thyristoren, Dioden etc. gebildet werden können. Nachfolgend wird der Stand der Technik sowie die erfinderische Idee anhand eines n- Kanal- IGBT beschrieben. Diese erfinderische Idee ist jedoch auf beliebige Leistungshalbleiterbauelemente mit mindestens einem sperrenden Übergang und einer Stoppschicht übertragbar.

Entsprechend eben geschildertem Sachverhalt wird in Punch- Through- IGBT (PT- IGBT) oder Non- Punch- Through- IGBT (NPT- IGBT) unterschieden. Dabei wurde in der Vergangenheit häufig bei PT- IGBT die Verwendung von Epitaxiewafern, bei NPT- IGBT die Verwendung von homogenem Wafermaterial (Bulk- Material) impliziert.

DE 43 13 170 A1 beschreibt PT- Bauelemente, insbesondere einen PT- IGBT, und gibt Wege zur Ausführung eines solchen Leistungshalbleiterbauelementes an. Zur Verringerung der Dicke des Halbleitersubstrates wird eine Stoppschicht verwendet. In Verbindung mit einem transparenten Rückseiten- Emitter werden kurze Tailströme und geringe Abschaltverluste erzielt. Stoppschicht und Rückseitenemitter werden durch Diffusion erzeugt. Vorteilhafte minimierte n⁻- Basiszonen können nur für hochsperrende Bauelemente (Sperrfähigkeit größer als 4.500 Volt) erreicht werden, bei denen die entsprechenden Waferdicken von > 400 µm prozeßtauglich sind. Für Sperrspannungen von 2.500 Volt bis 3.500 Volt ergeben sich bei PT- Auslegung der n⁻-Basiszone Waferdicken deutlich unter 400 µm. Hier sind alternativer Herstellungsverfahren notwendig.

Die bereits oben erwähnte EP 0330 122 A1 sowie die EP 0313 000 A1 beschreiben NPT-Bauelemente. Dickes monokristallines Silizium Material der ersten Leitfähigkeit wird auf der Vorderseite mit Bauelementestrukturen (DMOS- Transistorzellen) versehen. Nach Beendigung dieser vorderseitigen Bearbeitung wird der Wafer abgedünnt und in die Rückseite eine Dotierung der zweiten Leitfähigkeit mittels Implantation eingebracht und bei niedrigen Temperaturen aktiviert (<600°C). Die Implantationsdosis wird relativ niedrig gewählt, woraus sich ein kleiner Emitterwirkungsgrad ergibt, und die Eindringtiefe dieses Gebietes beträgt weniger als 1 µm. Die Dicke des Silizum Materials der ersten Leitfähigkeit ist nach der Abdünnung des Wafers von der Rückseite noch so groß, dass die Raumladungszone des gesperrten p/n- Übergangs im Bauelement nicht den rückseitigen p/n- Übergang berührt, es handelt sich also um ein NPT-Bauelement. Alternativ zur Implantation wird in der EP 0313 000 A1 vorgeschlagen, zur Erzeugung des Dotierungsgebietes der zweiten Leitfähigkeit auf der Rückseite eine Metall-Silizium- Legierung aufzubringen.

Die JP 02001985 beschreibt ein reines Wafer-, kein Bauelemente- Herstellungsverfahren, wobei mit diesen Wafern sowohl Leistungshalbleiterbauelemente mit niedriger wie auch hoher Blockierspannung realisiert werden können. Hier wird zunächst in den niedrig dotierten Ausgangswafer der ersten Leitfähigkeit beidseitig eine höhere Dotierung der ersten Leitfähigkeit eingebracht. Nachfolgend wird der beidseitig diffundierte Wafer von einer Seite abgeschliffen. Dieser Abtrag ist kleiner als die Diffusionstiefe. Anschließend wird auf die abgeschliffene Seite eine hochdotierte Epitaxieschicht der zweiten Leitfähigkeit aufgebracht, die als neues Trägermaterial für den gesamten Wafer und als Rückseitenemitter dient. Diese Epitaxieschicht ist sehr dick (Waferträger) und extrem hoch dotiert und dient als niederohmiges Anschlussgebiet. Zum Abschluß der Waferherstellung wird die der Epitaxieschicht abgewandte Seite abgeschliffen. Der Abtrag ist dabei größer als die Diffusionstiefe der Dotierung der ersten Leitfähigkeit. Erst nach diesen Schritten kann die Herstellung von Bauelementen auf der Wafervorderseite beginnen. Der Vorteil dieses Verfahrens gegenüber dem Stand der Technik besteht darin, daß die niedrig dotierte Basiszone der ersten Leitfähigkeit nicht aus epitaktisch abgeschiedenen Silizium, sondern aus homogenem Bulkmaterial besteht. Damit ist die Defektdichte in der niedrig dotierten Basiszone deutlich niedriger.

Weiterhin lassen sich mit vergleichbaren Kosten kleine wie auch große Dicken der Basiszone ausbilden. Nachteilig ist, dass ein Emitter mit niedriger Emittereffizienz nicht realisierbar ist, da im Interesse geringer ohmscher Verluste die Leitfähigkeit der Epitaxieschicht als neues Trägermaterial möglichst hoch gewählt werden muß. Damit macht sich eine (lokale) Absenkung der Ladungsträgerlebensdauer erforderlich, um akzeptable Schaltverluste zu erreichen.

Für einfach aufgebaute, bipolare Leistungsbauelemente (Dioden, Thyristoren) sind Herstellverfahren bekannt, die zu vergleichsweise niedrigen Dicken der n- Basiszone auf einkristallinem Wafermaterial führen. Beispielhaft aus der JP 60-145680 ist ein Verfahren zur Erzielung vergleichsweise niedrige Dicken der n-Basiszone unter Verwendung von einkristallinem Material bekannt. Hierzu wird der Prozess mit einer beidseitigen tiefen n- Diffusion gestartet. Danach werden wechselseitig Prozessschritte auf Vorder- (Waferabdünnen, p-Diffusion) und Rückseite (Waferabdünnen, p- Diffusion) ganzflächig ausgeführt. Die Erzeugung/ Fotolithografie der n+ Emitter und der Kontaktgebiete, der Passivierungen sowie der Metallisierung auf der Vorderseite erfolgt bei einer bereits vor diesen Verfahrensschritten erreichten Waferdicke. Auf Grund der vergleichsweise groben Strukturen der genannten Bauelement, der einfachen Technologie (kein MOS- Komplex) und der zum Zeitpunkt der Offenlegung verwendeten geringen Waferdurchmesser von 4 bzw. 5 Zoll, stellen die somit zu handhabenden Waferdicken bei der Vorderseitenbearbeitung kein Problem dar. Für komplexere Leistungshalbleiterbauelemente wie z.B. IGBTs, die mit komplizierteren Prozessschritten, kleinen Strukturabmessungen (Stepperlithografie) und der Verwendung von mindestens 6 oder 8 Zoll Wafern hergestellt werden, ist die Anwendung der hier offen gelegten Herstellungsmethode nicht mehr möglich. Die vorliegende Erfindung stellt ein Verfahren vor, bei dem PT- Typen mit dünnen n⁻- Basiszonen (im Bulk- Material) auf prozeßtauglichen Wafern mit Dicken von größer oder gleich 400 µm hergestellt werden können.

Die Erläuterungen erfolgen auf der Grundlage der Figuren 1 bis 5:
**Fig. 1** zeigt den Stand der Technik in Form eines nicht maßstabsgerechten Querschnittes eines n- Kanal- PT- IGBT im Ausschnitt auf der Basis von Epitaxiematerial.
**Fig. 2** skizziert analog zu Fig. 1 einen NPT- IGBT nach dem Stand der Technik auf der Grundlage von homogenem Grundmaterial.
**Fig. 3** skizziert einen Ausschnitt eines Waferquerschnittes nach dem technologischen Vorprozeß des Ausgangsmaterials auf der Grundlage der erfinderische Lösung.
**Fig. 4** skizziert einen Hochspannungs- PT- IGBT auf der Basis der Vordiffusion nach Fig. 3.
**Fig. 5** stellt einen Ausschnitt des rückseitig fertiggestellten Wafers nach Fig. 4 dar.

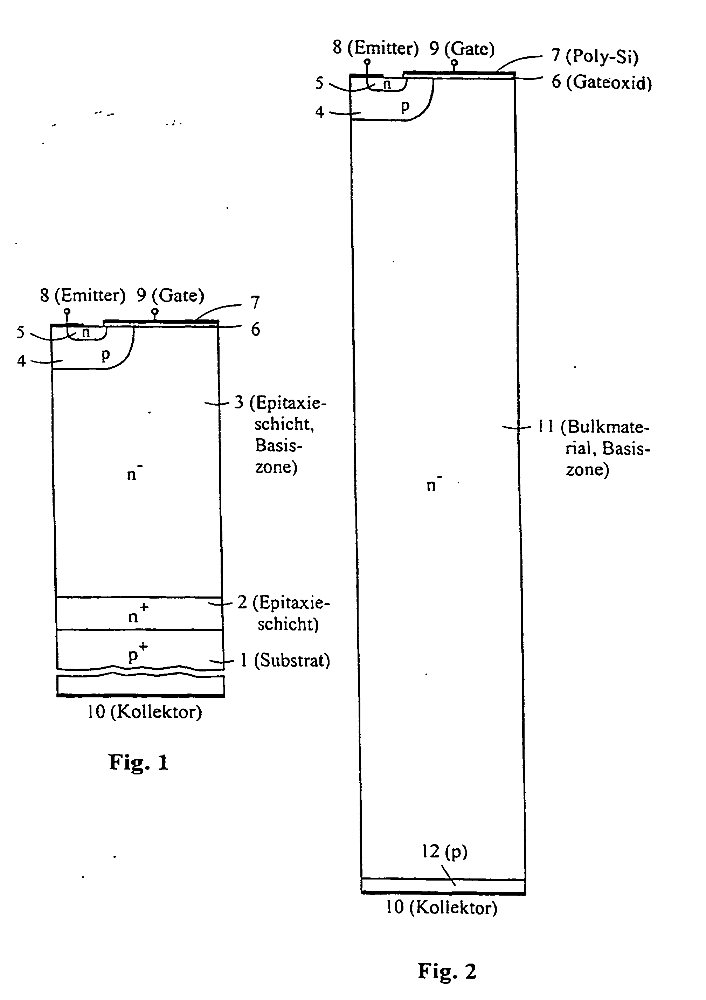

**Fig. 1** zeigt den Stand der Technik in Form eines nicht maßstabsgerechten Querschnittes eines n- Kanal- PT- IGBT im Ausschnitt auf der Basis von Epitaxiematerial. Für einen n- Kanal- PT-IGBT auf der Basis von Epitaxiematerial müssen nach dem Stand der Technik zwei Schichten auf einem p⁺- Substratmaterial (1) abgeschieden werden. Dabei wird mit einer mittel- bis hochdotierten n⁺- Schicht (2) begonnen, die die Stoppschicht bildet. Darauf wird als Driftzone eine n⁻- Schicht (3) epitaktisch aufgebracht. Die notwendige Dicke der n⁻- Schicht (3) hängt von dem zu erreichenden Sperrvermögen ab. Für die Sperrspannungsklasse 600 V sind beispielsweise ca. 50 µm, für 1200 Volt sind ca. 100 µm erforderlich.

Die weitere Herstellung des IGBT erfolgt in gleicher Weise analog dem Stand der Technik. Dabei bilden das p- Gebiet (4) den DMOS- Kanal (bzw. die Basis des npn- Transistors) und das n-Gebiet (5) den Emitter mit ihrer gemeinsamen Kontaktschicht (8).

Die Oxidschicht (6) und die Polysilizium- Schicht (7) bilden das Gate mit deren Kontaktelektrode (9) des Gesamtbauelementes. Der Kollektor (10) befindet sich an der Rückseite des Wafers.

**Fig. 2** skizziert analog zu Fig. 1 einen NPT- IGBT nach dem Stand der Technik auf der Grundlage von homogenem Grundmaterial. Wird zur Herstellung des IGBT ein n⁻- Bulk- Material (11) verwendet, muß der physikalische p- Emitter (12) von der Rückseite eingebracht werden, der gleichzeitig den Kollektor (10) des Gesamtbauelementes bildet. Zur Realisierung eines solchen NPT- Konzeptes wird nach dem Stand der Technik der gesamte Wafer nach vollständig erfolgter Strukturierung der Oberseite abgedünnt und von der Rückseite die p- Schicht implantiert.

Für 600 V wird die Basiszone (11) beispielsweise auf >100 µm und für 1200 V auf >170 µm abgedünnt. Die erforderliche Aktivierung des Emitters muß bei Temperaturen unter 450 °C erfolgen, da sonst die Metallisierung auf der Oberseite geschädigt oder gar zerstört wird.

Für Spannungen von <=600 V (220V- Netz, consumer electronic) werden in großem Umfang PT-IGBT auf der Basis von Epitaxiematerial eingesetzt. Für Sperrspannungen von etwa 1000 bis 1700 Volt (industrielle Anwendungen im Drehstromnetz) kommen im wesentlichen NPT- IGBT auf der Basis von homogenem Material zum Einsatz. IGBT werden in jüngster Zeit auch für Traktionsanwendungen und Hochspannungsnetze entwickelt und eingesetzt. Das hier erforderliche Sperrvermögen erstreckt sich gegenwärtig von 2400 Volt bis etwa 5000 Volt. Für solche Sperrfähigkeiten gibt es sowohl PT- als auch NPT- IGBT- Technologien zur Herstellung leistungsfähiger Halbleiterbauelemente.

Bei solchen Hochspannungs- NPT- IGBT muß entsprechend dem gewünschten Sperrvermögen eine große Waferdicke in Kauf genommen werden. Diese beträgt beispielsweise für die Spannungsklasse 3500 Volt etwa 500 µm. Die große Waferdicke führt zu vergleichsweise großen Flußspannungen und entsprechend großen Einschaltverlusten. Der Artikel "Progress in development of the 3,5 kV high voltage IGBT/Diode chipset and 1200A module application", von H. Brunner, Proceedings ISPSD, 1997, S. 225-228, zeigt diese Problematik.

Die Verwendung eines PT- Konzepts führt für Hochspannungs- IGBT zu deutlich kleineren Flußspannungen, in der die Weite der n⁻- Zone sich erheblich verringert. Für die Spannungsklasse 3500 Volt sind beispielsweise ca. 280 µm Weite ausreichend.

Eine Herstellung von Hochspannungs- PT- IGBT mittels Wafern mit Epitaxieschichten scheidet in einer praktikablen Technologie aus, da die erforderlichen Schichtdicken von größer 200 µm nicht sinnvoll abzuscheiden sind und die Anforderungen an Defektdichte und Dotierungshomogenität für hohe Sperrspannungen nicht erreicht werden. Daher wird ausschließlich homogenes Material eingesetzt, wobei nach dem Stand der Technik die erforderliche Stoppschicht zu Prozeßbeginn von der Rückseite eindiffundiert oder epitaktisch abgeschieden oder in einem Waferbondprozeß angebondet wird. Das Einbringen und die Ausdiffusion der Stoppschicht am Ende des Prozesses nach erfolgter Vorderseitenstrukturierung ist nicht möglich, da auch hier die Metallisierung auf der Vorderseite thermisch zerstört würde.

Das Problem der Realisierung von PT- IGBT für hohe Spannungen auf der Basis von homogenem Material ergibt sich aus fertigungstechnischen Aspekten. Die Waferdicken liegen nur geringfügig höher als die Dicke der n⁻- Basiszone, d.h. für 2500 Volt- Bauelemente ca. 200 µm und für Halbleiterbauelemente mit Sperrspannungen von 3500 Volt ca. 280 µm. Das bedeutet, daß über den gesamten Fertigungsprozeß Waferdicken von 200-300 µm vorliegen.

Übliche Herstellungsanlagen für Halbleiterbauelemente sind jedoch für Waferdicken von > 400 µm ausgelegt und so müßten diese für entsprechende Leistungsbauelemente mit hochsperrenden Eigenschaften kostenaufwendig komplett umgerüstet werden.

Weiterhin ist zu berücksichtigen, daß die Waferbruchrate ansteigt und mit sinkender Dicke die Waferdurchbiegung zunimmt, was z.B. bei der Photolithografie zu Problemen führt. Letzteres gilt in verschärftem Maße für die in Zukunft zu erwartenden größeren Waferdurchmessern von 6 bis 8 Zoll oder noch größere Wafer.

Die Aufgabe dieser Erfindung besteht darin, ein geeignetes Verfahren zur technologisch und wirtschaftlich vorteilhaften Herstellung von hochsperrenden Leistungshalbleiterbauelementen mit einer geringen n⁻- Basiszone bei großen Scheibendurchmessern praktizierbar zu gestalten.

Die Aufgabe dieser Erfindung wird durch die Maßnahmen des kennzeichnenden Teiles des Anspruches 1 gelöst, vorteilhafte Ausführungsvarianten sind in den nachgeordneten Ansprüchen gekennzeichnet.

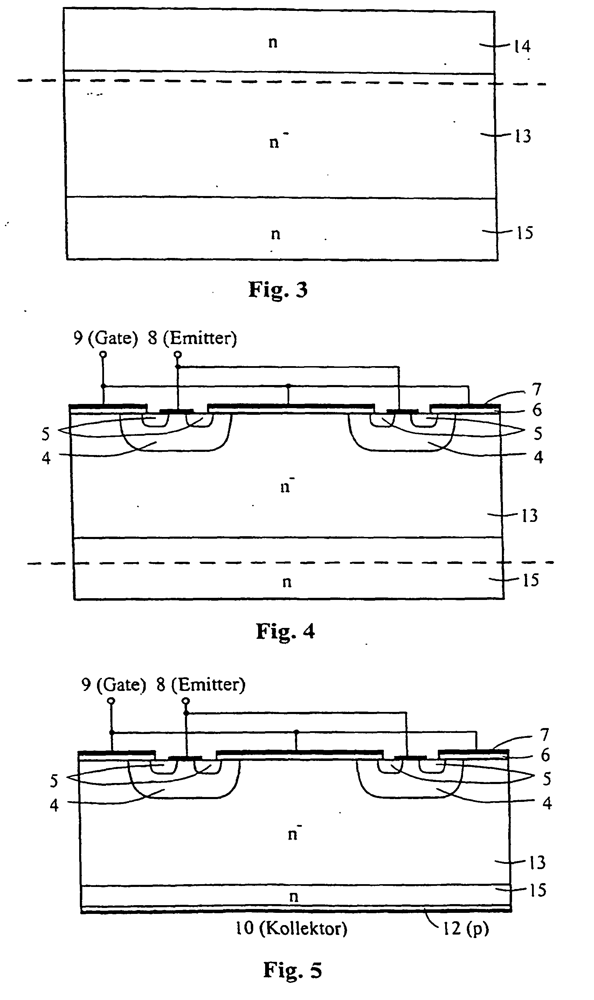

**Fig. 3** skizziert einen Ausschnitt eines Waferquerschnittes nach dem technologischen Vorprozeß des Ausgangsmaterials auf der Grundlage der erfinderische Lösung. Zunächst wird in den homogen n⁻- dotierten Si- Wafer (13) eine beidseitige tiefe n- Diffusion (14, 15) eingebracht. Die Eindringtiefe dieser n- Dotierung liegt dabei höher als es für die elektrische Wirkungsweise der Stoppschicht erforderlich wäre. Praktisch noch gut zu realisierende Eindringtiefen liegen z. B. bei ca. 150 µm. Prinzipiell wäre auch eine einseitige Diffusion ausreichend, sie scheitert aber praktisch an der Maskierung der nicht zu dotierenden Seite.

Nach der beidseitigen Tiefendiffusion wird die n- Dotierung (14) auf der Waferoberseite mittels Abschleifen vollständig entfernt und der Wafer anschließend poliert, angedeutet durch die gestrichelte Linie in der n⁻- Schicht (13). Weiterhin wird die Waferrückseite zur Verhinderung von Autodoping versiegelt. Die Waferdicke liegt nunmehr in einem für die Fertigung beherrschbaren Bereich, z.B. für Sperrspannungen von 3500 Volt bei ca. 430 µm und für Sperrspannungen von 2500 Volt bei ca. 350 µm.

**Fig. 4** skizziert einen Hochspannungs- PT- IGBT auf der Basis der Vordiffusion nach Fig. 3. Nach dem Polierprozeß durchläuft der Wafer den üblichen Prozeß zur Herstellung der IGBT-Zellstruktur auf der Vorderseite. Dabei sind alle nur denkbaren Zellformen und -arten möglich, wie sie nach dem Stand der Technik beschrieben sind.

Das p- Gebiet (4) bildet dabei den DMOS- Kanal des IGBT bzw. die Basis eines npn- Transistors, das n⁺- Gebiet (5) bildet den Emitter, die Oxidschicht (6) und die Polysilizium- Schicht (7) das Gate des Gesamtbauelementes bei IGBT- Aufbauten.

Nach Abschluß der vollständigen Prozeßfolge zur Realisierung der Vorderseite (Zellstruktur) wird der Wafer von der Rückseite abgeschliffen, markiert durch die gestrichelte Linie in der n-Dotierungsschicht (15). Dabei verbleibt von der eingebrachten n- Dotierung (15) mindestens eine solche vertikale Ausdehnung als Reserve, die einen Punch- Through- Durchbruch verhindert. Für eine Diffusionstiefe der Stoppschicht beispielsweise von 150 µm kann eine Reduzierung auf ca. 25µm erfolgen (Punch- Through- Reserve). Durch diesen erfindungsgemäßen Prozeßablauf stehen für den Herstellungsablauf der IGBT- Zellen im Beispiel ca. 125 µm mehr Scheibendicke gegenüber dem Stand der Technik zur Verfügung.

**Fig. 5** stellt einen Ausschnitt des rückseitig fertiggestellten Wafers dar. Anschließend an das Abschleifen der Rückseite des Wafers wird der p- Rückseitenemitter (12) von der Rückseite aus implantiert und aktiviert. Die übrige skizzierte Konfiguration ist unter Fig. 4 beschrieben. Das Verfahren der Ausbildung des Kollektors entspricht dem Stand der Technik, das bisher hauptsächlich für NPT- IGBT zur Erzeugung des Rückseitenemitters angewendet wurde.

Auch hier muß die Aktivierung des Emitters bei Temperaturen unter 450 °C erfolgen, da sonst die Metallisierung auf der Oberseite geschädigt oder gar zerstört wird. Der Kollektor (10) befindet sich an der Rückseite des Wafers.

Durch die erfinderische Idee ist die Dotierung der Stoppschicht relativ niedrig (Ausläufer des Diffusionsgebietes), so daß über die Dotierung des Rückseitenemitters der Emitterwirkungsgrad und die Ladungsträgerverteilung in der n⁻- Basiszone in weiten Bereichen eingestellt werden kann. Ein niedriger Dotierungsgradient zwischen Stoppschicht und Rückseitenemitter läßt die Flußspannung ansteigen, während die Schaltverluste und Sättigungsströme sinken, bei einem höheren Gradienten fällt die Flußspannung während die Schaltverluste und Sättigungsströme wachsen.

Alternativ zur Aktivierung des p- Emitters ist auch der Einsatz von RTP/RTA- Verfahren möglich (Rapid Thermal Processing/ Rapid Thermal Annealing: Prozesse zur extrem kurzzeitigen lokalen Erwärmung (u.U. bis zur Aufschmelzung) des Halbleitermaterials, bei dem kaum eine Diffusion und eine hohe Aktivierung der Dotanden stattfindet), wodurch eine gesteigerte Aktivierung der Dotanden und damit eine geringere Flußspannung erreicht wird. Auch kann die Erzeugung des p-Emitters durch eine Epitaxieschicht- Abscheidung bei Temperaturen unter 450°C erfolgen.

Weiterhin ist auch eine Kombination der hier beschriebenen erfinderischen Idee mit der Vorgehensweise entsprechend dem Stand der Technik möglich. Beispielsweise kann bis zur Abscheidung und Strukturierung des Aluminiums der Oberseite (Emitter) der Wafer mit der noch nicht in der Dicke reduzierten Stoppschicht verwendet werden. Unmittelbar vor der Abscheidung und Strukturierung des Aluminiums der Oberseite wird die Stoppschicht in ihrer Dicke verringert und der Emitter von der Rückseite implantiert sowie aktiviert.

Vorteilhaft kann hier eine deutlich höhere Aktivierungstemperatur als 450°C gewählt werden, da keine Metallisierungsschichten thermisch geschädigt werden können. Ein Umrüsten für dünne Wafer ist nur für diejenigen Anlagen nötig, die für die Erzeugung und Strukturierung der Al-Metallisierung sowie für die nachfolgenden Passivierungsschichten erforderlich sind.

## Patentansprüche

1. Verfahren zur Herstellung eines Punch- Through- Leistungshalbleiterbauelements mit mindestens einem eine hohe Spannung sperrenden pn- Übergang ausgehend von einem monokristallinen Halbleiter-Wafer mit einer ersten Leitfähigkeit in niedriger Dotierung, wobei dieses Leistungshalbleiterbauelement eine Basiszone (13) dieser ersten Leitfähigkeit und niedriger Dotierung, eine Stoppschicht (15) der ersten Leitfähigkeit mit höherer Dotiertung, einen Emitter einer zweiten Leitfähigkeit auf der unterseite des Leistungshalbleiter bauelements und weitere Diffusionsgebiete (4,5) verschiedener Leitfähigkeit auf der Oberseite des Leistungshalbleiterbauelements aufweist,
mit den folgenden aufeinander folgenden Verarbeitungsschritten:
- gleichzeitige Diffusion der Stoppschicht (15) auf der Waferunterseite und einer weiteren Schicht (14) der ersten Leitfähigkeit auf der Waferoberseite, in den monokristallinen Halbleiter-Wafer;
- vollständiges Entfernen der weiteren Schicht (14) von der Waferoberseite;
- Ausbildung aller der obergenannten weiteren Diffusionsgebiete (4,5) auf der Waferoberseite zur Ausbildung der Funktionalität des Leistungshalbleiterbauelements;
- Verringern der Schichtdicke der Stoppschicht (15) auf der Waferunterseite;
- Ausbildung des Emitters (12) auf der Waferunterseite.

2. Verfahren nach Anspruch 1, **dadurch gekennzeichnet, dass** die Stoppschicht (15) und die weiteren Schicht (14) gleichzeitig ca. 150µm tief diffundiert werden.

3. Verfahren nach Anspruch 1, **dadurch gekennzeichnet, dass** die weitere Schicht (14) mittels Schleifen und / oder Polieren entfernt wird.

4. Verfahren nach Anspruch 1, **dadurch gekennzeichnet, dass** nach dem Entfernen der weiteren Schicht und vor dem Verringern der Schichtdicke der Stoppschicht weitere Prozessschritte zur Ausbildung einer Oxidschicht (6) und einer Polysiliziumschicht (7) erfolgen.

5. Verfahren nach Anspruch 2, **dadurch gekennzeichnet, dass** die Verringerung der Schichtdicke der Stoppschicht (15) auf ca. 25µm erfolgt.

6. Verfahren nach Anspruch 1, **dadurch gekennzeichnet, dass** der Emitter (12) mittels Implantation und Niedertemperatur- Ausheilung oder Niedertemperatur- Epitaxie hergestellt wird.

7. Verfahren nach Anspruch 1, **dadurch gekennzeichnet, dass** der Emitter (12) mittels Einbringen von Dotanden und Aktivierung dieser Dotanden durch RTP/RTA-Verfahren hergestellt wird.

## Claims

1. Method for the production of a Punch-Through-power semiconductor component with at least one pn- transition blocking a high voltage starting from a single-crystal semiconductor wafer with a first conductivity in low doping, wherein the power semiconductor component has a base zone (13) of the first conductivity and low doping, a stop layer (15) of the first conductivity with high doping, an emitter of a second conductivity on the under side of the power semiconductor component and further diffusion regions (4, 5) of different conductivity on the upper side of the power semiconductor element, with the following one after another following process steps:
- simultaneous diffusion of the stop layer (15) on the wafer under side and a further layer (14) of the first conductivity on the wafer upper side, in the single-crystal semiconductor wafer;
- complete removal of the further layer (14) from the wafer upper side;
- formation of all of the above named further diffusion regions (4, 5) on the wafer upper side (4, 5) for the formation of the functionality of the power semiconductor element;
- reducing the layer thickness of the stop layer (15) on the wafer under side;
- formation of the emitter (12) on the wafer under side.

2. Method according to Claim 1, **characterised in that**, the stop layer (15) and the further layer (14) are simultaneously diffused ca. 150 µm deep.

3. Method according to Claim 1, **characterised in that**, the further layer (14) is removed by means of lapping and/or polishing.

4. Method according to Claim 1, **characterised in that**, after the removal of the further layer and before the reducing of the layer thickness of the stop layer, further process steps for the formation of an oxide layer (6) and of a polysilicon layer (7) are carried out.

5. Method according to Claim 2, **characterised in that**, the reduction of the layer thickness of the stop layer (15) is carried out to ca. 25 µm.

6. Method according to Claim 1, **characterised in that**, the emitter (12) is produced by means of implantation and low temperature-annealing or low temperature- epitaxy.

7. Method according to Claim 1, **characterised in that**, the emitter (12) is produced by means of introducing of dopants and activation of the dopants by RTP/RTA processes.

## Revendications

1. Procédé de fabrication d'un composant semi-conducteur de puissance Punch-Through avec au moins une jonction pn bloquant une haute tension à partir d'une tranche semi-conductrice monocristalline avec un premier type de conductivité en dopage faible, ce composant semi-conducteur de puissance comportant une zone de base (13) de ce premier type de conductivité et faiblement dopée, une couche d'arrêt (15) du premier type de conductivité plus fortement dopée, un émetteur d'un deuxième type de conductivité sur la face inférieure du composant semi-conducteur de puissance et d'autres zones de diffusion (4, 5) de type de conductivité différent sur la face supérieure du composant semi-conducteur de puissance,
avec les étapes de traitement successives ci-dessous :
- diffusion simultanée de la couche d'arrêt (15) sur la face inférieure et d'une autre couche (14) du premier type de conductivité sur la face supérieure de tranche, dans la tranche semi-conductrice monocristalline ;
- élimination totale de l'autre couche (14) de la face supérieure de tranche ;
- formation de toutes les autres zones de diffusion (4, 5) mentionnées ci-dessus sur la face supérieure de tranche pour réaliser la fonctionnalité du composant semi-conducteur de puissance ;
- réduction de l'épaisseur de la couche d'arrêt (15) sur la face inférieure de tranche ;
- formation de l'émetteur (12) sur la face inférieure de tranche.

2. Procédé selon la revendication 1, **caractérisé en ce que** la couche d'arrêt (15) et l'autre couche (14) sont diffusées simultanément sur une profondeur de 150 µm environ.

3. Procédé selon la revendication 1, **caractérisé en ce que** l'autre couche (14) est éliminée au moyen d'une rectification et/ou d'un polissage.

4. Procédé selon la revendication 1, **caractérisé en ce que**, après l'élimination de l'autre couche et avant la réduction de l'épaisseur de la couche d'arrêt, d'autres étapes de processus sont effectuées pour la formation d'une couche d'oxyde (6) et d'une couche de polysilicium (7).

5. Procédé selon la revendication 2, **caractérisé en ce que** la réduction de l'épaisseur de la couche d'arrêt (15) s'effectue à 25 µm environ.

6. Procédé selon la revendication 1, **caractérisé en ce que** l'émetteur (12) est fabriqué au moyen d'une implantation et d'un recuit à basse température ou d'une épitaxie à basse température.

7. Procédé selon la revendication 1, **caractérisé en ce que** l'émetteur (12) est fabriqué au moyen de l'ajout d'agents dopants et de l'activation de ces agents dopants par un procédé RTP/RTA.
